Europäisches Patentamt

European Patent Office

Office européen des brevets

(11) Veröffentlichungsnummer: **0 350 120 B1**

(12) **EUROPÄISCHE PATENTSCHRIFT**

(45) Veröffentlichungstag der Patentschrift: **01.06.94**

(51) Int. Cl.⁵: **G01R 33/50**, G01R 33/56

(21) Anmeldenummer: **89201752.6**

(22) Anmeldetag: **03.07.89**

(54) **Verfahren und Kernspinresonanzanordnung zur Schnellbestimmung der Transversal-Relaxationszeit T2.**

(30) Priorität: **08.07.88 NL 8801731**

(43) Veröffentlichungstag der Anmeldung:
**10.01.90 Patentblatt 90/02**

(45) Bekanntmachung des Hinweises auf die Patenterteilung:
**01.06.94 Patentblatt 94/22**

(84) Benannte Vertragsstaaten:
**CH DE ES FR GB IT LI**

(56) Entgegenhaltungen:
**EP-A- 0 199 202**
**EP-A- 0 269 371**
**GB-A- 2 140 569**
**US-A- 4 720 679**

**MAGNETIC RESONANCE IN MEDICINE, Band 7, Nr. 1, Mai 1988, Seiten 35-42, Academic Press, Inc., Duluth, MN, US; H. BRUDER et al.: "A new steady-state imaging sequence for simultaneous acquisition of two MR images with clearly different contrasts"**

**MAGNETIC RESONANCE IN MEDICINE, Band 6, Nr. 2, Februar 1988, Seiten 224-234, Academic Press, Inc., Duluth, MN, US; T.W. RED-**

**PATH et al.: "FADE - A new fast imaging sequence"**

**JOURNAL OF MAGNETIC RESONANCE, Band 76, Nr. 3, 15. Februar 1988, Seiten 440-457, Academic Press, Inc., Duluth, MN, US; E.M. HAACKE et al.: "T2 deconvolution in MR imaging and NMR spectroscopy"**

(73) Patentinhaber: **N.V. Philips' Gloeilampenfabrieken**
**Groenewoudseweg 1**
**NL-5621 BA Eindhoven(NL)**

(72) Erfinder: **Mehlkopf, Antoon Frans**
**c/o INT. OCTROOIBUREAU B.V.**
**Prof. Holstlaan 6**
**NL-5656 AA Eindhoven(NL)**
Erfinder: **Prins, Willem Marten**
**c/o INT. OCTROOIBUREAU B.V.**
**Prof. Holstlaan 6**
**NL-5656 AA Eindhoven(NL)**

(74) Vertreter: **Faessen, Louis Marie Hubertus et al**
**INTERNATIONAAL OCTROOIBUREAU B.V.,**
**Prof. Holstlaan 6**
**NL-5656 AA Eindhoven (NL)**

**Beschreibung**

Die Erfindung betrifft ein bildgebendes Verfahren auf der Basis von einer Bildgebendes Verfahren auf der Basis einer Kernspinparameterverteilung in einem Teil eines Körpers, wobei, während einer Anzahl von Meßzyklen, in einem statischen Magnetfeld im Körper Kernspins zum Erzeugen eines Kernspinresonanzsignals (E) angeregt werden, das darauf bei einem dem statischen Magnetfeld überlagerten Magnetfeldgradienten (Gx) abgetastet wird, wobei ein zweiter Magnetfeldgradient (Gy), mit einem von Meßzyklus zu Meßzyklus unterschiedlichen Zeitintegral, vor dem Resonanzsignal (E) vorübergehend eingeschaltet ist, wonach die auf diese Weise abgetasteten Resonanzsignale (E) durch Signaltransformation in ein Bild der vorgenannten Verteilung umgesetzt werden. Die abgetasteten Resonanzsignale im beschriebenen Verfahren können Impulsechosignale oder Feldechosignale sein.

Die Erfindung bezieht sich weiter auf eine Kernspinresonanzanordnung mit einem Magnetsystem zum Erzeugen eines statischen homogenen Magnetfeldes und zum Erzeugen von Magnetfeldgradienten, mit einem Hf-Sender/Empfänger zum Erzeugen und Detektieren von Kernspinresonanzsignalen, mit einer Abtastanordnung zum Abtasten der erzeugten Resonanzsignale, mit einer Signaltransformationsanordnung zum Transformieren der abgetasteten Kernspinresonanzsignale, mit einer Wiedergabeanordnung zum Wiedergeben der transformierten Signale, und mit einer Steueranordnung zum Steuern des Magnetsystems, des Hf-Senders/Empfängers, der Abtastanordnung, der Signaltransformationsanordnung und der Wiedergabeanordnung.

Ein derartiges Verfahren und eine derartige Anordnung sind aus der US-PS 4 070 611 bekannt und werden oft zum Geben von in vivo Bildern angewandt, die auf Dichte und anderen Eigenschaften der Kernspinverteilung im untersuchten Objekt basieren. Weiter ist aus der PCT-Anmeldung WO 85/02264 ein Verfahren zum Synthetisieren derartiger Bilder eines Objektes oder eines Objektteils bekannt. Es wird dabei davon ausgegangen, daß die Signalstärke in einem Punkt eines Bildes durch die örtliche Magnetisierung MO, durch die örtlichen Longitudinal- und Transversal-Relaxationszeiten T1 und T2 und durch die in der Meßmethodik benutzten Parameter bestimmt wird, wie z.B. die Wiederholungszeit der Meßzyklen TR und die Wartezeit TE, die zwischen der Erregung am Anfang des Meßzyklus und dem Zeitpunkt der Abtastung des Kernspinresonanzsignals verläuft. Durch die Bestimmung einer Anzahl von Bildern, bei denen sowohl der Meßparameter TR als auch der Meßparameter TE variiert werden, können je Bildelement die Magnetisierung MO und die Longitudinal- und Transversal-Relaxationszeiten T1 und T2 berechnet werden. Sind einmal diese Daten bekannt, ist es möglich, für beliebige TR und TE synthetische Bilder aufzubauen als wären sie während einer durch diese Parameter TR und TE gekennzeichneten Messung erhalten. Auf diese Weise sind Bilder synthetisierbar, bei denen der Kontrast zwischen den verschiedenen Bildteilen optimiert werden kann. Beim beschriebenen Verfahren wird also immer eine Anzahl vollständiger Bilder benötigt, bevor synthetische Bilder aufgebaut werden können. Dies hat direkte Folgen für die erforderliche Meßzeit, also für die Dauer, die ein Objekt in der Kernspinresonanzanordnung verweilen muß.

Der Erfindung liegt die Aufgabe zugrunde, ein Verfahren und eine Kernspinresonanzanordnung zu schaffen, mit denen auf schnelle Weise verschiedene Kernspinresonanzparameter von Bildelementen in einem Objekt bestimmbar sind, und zwar die Kernspindichte ρ (oder auch die Gleichgewichtsmagnetisierung MO) und die Transversal-Relaxationszeit T2, bei der nur eine Echomatrix für eine Kernspindichteverteilung, d.h. nur eine Bildfrequenzmatrix, erfaßt zu werden braucht.

Zur Lösung dieser Aufgabe ist ein Verfahren erfindungsgemäß dadurch gekennzeichnet, daß die erzeugten Kernspinresonanzsignale (E) Spinechosignale oder Gradientenechosignale sind, daß die Kernspinparameterverteilung eine Transversal-Relaxationszeitverteilung ist und daß aus der zeitlichen Asymmetrie des abgetasteten Kernspinresonanzsignals (E) bezüglich seines Signalmaximums, die durch die Transversal-Relaxation der angeregten Kernspins verursacht wird, ein Maß für die ortsabhängige Verteilung der Transversal-Relaxationszeit (T2) abgeleitet wird.

Beim erfindungsgemäßen Verfahren wird die Tatsache ausgenutzt, daß die Transversal-Relaxation das Kernspinechosignal zeitabhängig beeinflußt. Diese Beeinflussung ist eine exponentielle Funktion (exp -t/T2), worin T2 die Transversal-Relaxationszeit darstellt. Es sei bemerkt, daß die Zeit T2(x,y,z) ortsabhängig ist und pro Bildelement eines zu rekonstruierenden Bildes abweichen kann.

Ein Ausführungsbeispiel eines erfindungsgemäßen Verfahrens zur Bestimmung der Kernspindichteverteilung und der Verteilung der Transversal-Relaxationszeit T2 in einem Teil eines Körpers, wobei im Körper, während einer Anzahl von Meßzyklen, bei einem statischen Magnetfeld Kernspins zum Erzeugen eines Kernspinresonanzsignals (E) angeregt werden, und aus den auf diese Weise gewonnenen Resonanzsignalen (E) durch Signaltransformation obige Verteilungen bestimmt werden, ist dadurch gekennzeichnet, daß das Kernspinresonanzsignal (E) bei einem Magnetfeldgradienten (Gx) abgetastet wird, der dem statischen Magnetfeld überlagert ist und eine erste Richtung hat, daß ein zweiter Magnetfeldgradient (Gy) in einer zweiten Richtung, mit einem von Meßzyklus zu Meßzyklus unterschiedlichen Zeitintegral, vor dem Resonanzsignal (E) vorübergehend eingeschaltet ist, daß die Signaltransformation eine Fouriertransformation enthält, daß das Kernspinresonanzsignal (E) ein Spinechosignal oder Gradientenechosignal ist, das mit einer derartigen Phase erfaßt oder dessen Phase vor oder nach der Fouriertransformation derart korrigiert wird, daß das Ergebnis der Fouriertransformation und der gegebenenfalls danach durchgeführten Korrektur, ohne Transversal-Relaxation rein reell wäre, und daß nach der Fouriertransformation und gegebenenfalls der Korrektur von Signalproben der Kernspinresonanzsignale (E) der Imaginärteil der transformierten Signale in der ersten Richtung integriert wird, wonach die Verteilung der Transversal-Relaxationszeit (T2) aus dem Quotienten des Realteils und des integrierten Imaginärteils der transformierten Signale bestimmt wird, und daß die Kernspindichteverteilung aus der so bestimmten Verteilung der Transversal-Relaxationszeit (T2) und dem Realteil der transformierten Signale oder auf andere Weise durch Signaltransformation der abgetasteten Resonanzsignale bestimmt wird.

Ergänzend ist ein mögliches Verfahren wobei von einer derart bestimmten Verteilung ein aus Bildelementen bestehendes Bild konstruiert wird, dadurch gekennzeichnet daß für jene Bildelemente, deren integrierter Imaginärteil der transformierten Signale zur Bestimmung des genannten Quotienten zu klein ist, die Bestimmung des Quotienten durch eine andere Bearbeitung, wie z.B. eine Interpolation aus umgebenden Bildelementen, ersetzt wird.

Bei einem anderen möglichen Verfahren wird die Integration von Signalen nach der Fouriertransformation durch eine signalbearbeitungstechnisch gleichwertige Bearbeitung für die Fouriertransformation ersetzt, d.h. durch Filterung mit einer Filterfunktion gleich der Gewichtungsfunktion (1/t) oder einer davon abgeleiteten Gewichtungsfunktion.

Die Erfindung nutzt die Tatsache aus, daß ein Kernspinresonanzsignal durch die Transversal-Relaxationszeit T2 beeinflußt wird. Zunächst ist die absolute Signalgröße proportional $\exp(-TE/T2)$. An zweiter Stelle besitzt das abgetastete Kernspinresonanzsignal durch diese Transversal-Relaxationszeit T2 eine bestimmte Asymmetrie. Es ist möglich, dieser Asymmetrie genügend Information zu entziehen, um aus derselben MRI-Messung sowohl ein Bild der Kernspindichte $\rho(x,y,z)$ als auch ein Bild der Zeit $T2(x,y,z)$ zu bestimmen.

Nach der Fouriertransformation eines in einer Abtastperiode erhaltenen Kernspinresonanzsignals wird eine Frequenzverteilung mit einem Real- und einem Imaginärteil gefunden. Nur wenn das Kernspinresonanzsignal mit der richtigen Phase abgetastet wird, ergibt der Realteil dieser Frequenzverteilung die Verteilung $\rho(x,y,z) * \exp(-TE/T2(x,y,z))$. Normalerweise bleibt der Imaginärteil unberücksichtigt oder es wird beim Berechnen von Modulusbildern und ihrer Verwertung der Einfluß dieses Termes vernachlässigt. Dies ist jedoch erst ganz richtig, wenn es keinen Einfluß der Transversal-Relaxationszeit T2 gäbe.

Der Imaginärteil eines derartigen transformierten Signals wird nämlich durch den Ausdruck

$$-d/dx\{C * \rho(x,y,z) * 1/T2(x,y,z) * \exp(-TE/T2(x,y,z))\}$$

gegeben, also als Ableitung nach x, der mit der Richtung des Lesegradienten übereinstimmenden Koordinate des Produkts einer Konstante C abhängig von der Stärke des Lesegradienten und des gyromagnetischen Verhältnisses des detektierten Kerns, der Kernspindichte $\rho(x,y,z)$, des Gewichtungsfaktors $\exp(-TE/T2(x,y,z))$ und des Inversen der Transversal-Relaxationszeit $T2(x,y,z)$. Wenn dieser Imaginärteil abhängig von der Koordinate x integriert wird, so daß das Signal

$$\rho(x,y,z) * 1/T2(x,y,z) * \exp(-TE/T2(x,y,z))$$

entsteht und anschließend der Realteil des Ergebnisses der Fouriertransformation durch diesen integrierten Imaginärteil geteilt wird, ist dieser Quotient mit hoher Genauigkeit ein Wert für die Transversal-Relaxationszeit $T2(x,y,z)$. Wenn er einmal bekannt ist, kann daraus zusammen mit dem Realteil des fouriertransformierten Kernspinresonanzsignals auch eine sehr genaue Kernspindichte $\rho(x,y,z)$ bestimmt werden.

Ein mögliches Ausführungsbeispiel des erfindungsgemäßen Verfahrens ist dadurch gekennzeichnet, daß nach der Fouriertransformation von Signalproben der Kernspinresonanzsignale der Imaginärteil der transformierten Signale integriert wird, wonach der Quotient des Real- und des integrierten Imaginärteils der transformierten Signale bestimmt wird, wobei außerdem dafür gesorgt wird, daß das Kernspinresonanzsignal mit einer derartigen Phase erfaßt wird, daß die Fouriertransformierte dieses Signals ohne Transversal-Relaxation rein reell wäre, also bei einer unendlich langen T2-Zeit.

Ein anderes mögliches Ausführungsbeispiel des erfindungsgemäßen Verfahrens kennzeichnet eine derartige Phasenkorrektur des Kernspinresonanzsignals, daß das Signal nach der Fouriertransformation der Bedingung entspricht, daß es ohne Transversal-Relaxation rein reell wäre, wobei nach der Fouriertransformation dieser phasenkorrigierten Signalproben der Imaginärteil der transformierten Signale integriert wird, wonach, wenn der integrierte Imaginärteil der transformierten Signale dazu nicht zu Klein ist, der Quotient des Real- und des integrierten Imaginärteils des transformierten Signals bestimmt wird. Für Bildelemente, deren integrierter Imaginärteil der transformierten Signale zu Klein ist, wird die Bestimmung des Quotienten durch eine andere Bearbeitung ersetzt, wie z.B. durch Einschätzung aus umgebenden Bildelementen oder durch vorausgesetzte Nullstellung des Ergebnisses.

Eine andere mögliche Ausführungsform des Verfahrens nach der Erfindung ist dadurch gekennzeichnet, daß die Integration von Signalen nach der Fouriertransformation durch eine signalbearbeitungstechnisch gleichwertige Bearbeitung für die Fouriertransformation, und zwar durch Filterung mit einer Filterfunktion ersetzt wird, die gleich der Gewichtungsfunktion 1/t oder einer davon abgeleiteten Gewichtungsfunktion ist.

Ein bevorzugtes Ausführungsbeispiel des erfindungsgemäßen Verfahrens ist dadurch gekennzeichnet, daß die Imaginärteile der Fouriertransformierten der erhaltenen Signale, gegebenenfalls korrigiert, in die genannte erste Richtung integriert werden mittels eines laufenden Integrals, und daß zur Bestimmung der Verteilung der Transversal-Relaxationszeit T2, für jedes Bildelement der dazu gehörende Realteil der erwähnten Fouriertransformierten geteilt wird durch das Ergebnis dieses laufenden Integrals auf die Position des Bildelements.

Mittels der in diesem Verfahren bestimmten Verteilung der Transversal-Relaxationszeit T2 ist es möglich, das zum Realteil der Fouriertransformierten gehörende Bild derart zu korrigieren, daß bei gleicher Auflösung eine reine Kernspindichteverteilung $\rho$ des gleichen Teils des Körpers gefunden wird, als jenes Teils, dessen Verteilung der Transversal-Relaxationszeit T2 bestimmt ist.

Eine erfindungsgemäße Kernspinresonanzanordnung ist dadurch gekennzeichnet, daß die Kernspinresonanzsignale (E) Spinechosignale oder Gradientenechosignale sind, daß die Abtastanordnung zum Erfassen der Resonanzsignale mit einer derartigen Phase angepaßt ist oder daß Korrekturmittel für eine derartige Korrektur der Signalphase vor oder nach der Transformation vorgesehen sind, daß das Ergebnis der Transformation und der gegebenenfalls danach durchgeführten Korrektur, ohne Transversal-Relaxation rein reell wäre, und daß die Signaltransformationsanordnung Rechenmittel zum Integrieren der Imaginärteile der Signaltransformierten der abgetasteten Kernspinresonanzsignale und zum Bestimmen des Quotienten der Realteile der Signaltransformierten und dieser integrierten Imaginärteile enthält.

Bei der erfindungsgemäßen Anordnung ist es mit einer Mindestmenge zusätzlicher Software- und/oder Hardware-Bauteile möglich, sowohl die Kernspindichteverteilung als auch die Verteilung der Transversal-Relaxationszeit in nur einer Messung zu bestimmen, d.h. aus nur einer erfaßten Bildfrequenzmatrix.

Ein bevorzugtes Ausführungsbeispiel einer erfindungsgemäßen Kernspinresonanzanordnung, in der die Signaltransformationsanordnung eine Fouriertransformation durchführt und Speichermittel zum Speichern der Real- und Imaginärteile der Fouriertransformierten der Kernspinresonanzsignale (E) enthält, ist dadurch gekennzeichnet, daß weitere Speichermittel zum Speichern der Integralwerte der Imaginärteile und/oder zum Speichern des Quotienten der Realteile der Fouriertransformierten und der zugeordneten Werte dieses Integrals vorgesehen sind. Bei der Kernspinresonanzanordnung nach der bevorzugten Ausführungsform der Erfindung sind nur zusätzliche Speichermittel zur Größe eines Bildes und je Bildelement im Prinzip nur zwei zusätzliche Berechnungen zur Bestimmung der Verteilung der Transversal-Relaxationszeit T2 erforderlich.

Ausführungsbeispiele der Erfindung werden nachstehend anhand der Zeichnung näher erläutert. Es zeigen

Fig. 1 eine erfindungsgemäße Anordnung,

Fig. 2 ein Ausführungsbeispiel eines erfindungsgemäßen Meßzyklus, und

Fig. 3 in einem Ablaufdiagramm ein Beispiel der Verarbeitung der Signale aus dem Meßzyklus nach Fig. 2.

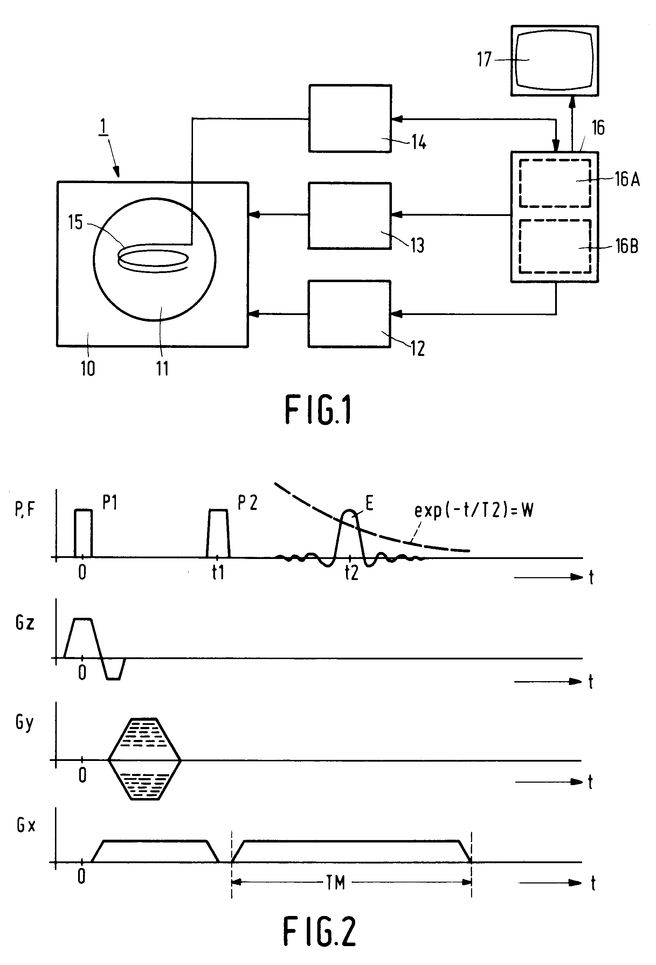

Die in Fig. 1 dargestellte Kernspinresonanzanordnung I enthält ein Magnetsystem 10 zum Erzeugen eines statischen homogenen Magnetfelds und der Magnetfeldgradienten. Die Magnetfelder werden in einem Untersuchungsraum 11 erzeugt, in dem sich das zu untersuchende Objekt befindet, das beispielsweise ein Patient sein kann. Das Magnetsystem 10 wird mit den Generatoren 12 und 13 angesteuert, von denen der Generator 12 das statische Magnetfeld und der Generator 13 einen Magnetfeldgradienten erzeugt, der eine beliebige Richtung haben kann. Das Magnetsystem 10 enthält eine Widerstandsspule oder eine vom Generator 12 gesteuerte Supraleitspule zum Erzeugen eines homogenen statischen Magnetfelds.

Die Kernspinresonanzanordnung 1 enthält weiter einen Sender/Empfänger 14, der eine Sende/Empfangsspule 15 ansteuert. Nach dem Ansteuern der Sendespule 15 sind in dem im Untersuchungsraum 11 befindlichen zu untersuchenden Objekt Kernspinresonanzsignale erzeugt, die mit der Empfangsspule 15 detektiert und dem Empfänger im Sender/-Empfänger 14 zugeführt werden. Abhängig von der durchzuführenden Meßtechnik kann als Sendespule sowie als Empfangsspule dieselbe Spule oder können zum Senden und Empfangen getrennte Spulen verwendet werden. Die detektierten Resonanzsignale werden abgetastet, digitalisiert und in Digitalform einer Zentraleinheit 16 zugeführt. Das Erzeugen, Detektieren und Digitalisieren der Kernspinresonanzsignale im Empfänger 14 wird weiter unten näher erläutert. Die Einheit 16 enthält eine Signaltransformationsanordnung 16a sowie eine Steuer- und Regeleinheit 16b, die die Generatoren 12 und 13 sowie den Sender/Empfänger 14 steuert und ihre Wirkung synchronisiert. Die Signaltransformationsanordnung 16a verarbeitet die gemessenen Resonanzsignale zu einem Bild des angeregten Teils des Objekts. Weiter ist eine Wiedergabeanordnung 17, beispielsweise ein Monitor, zum Wiedergeben des rekonstruierten Bildes vorgesehen.

In Fig. 2 ist eine an sich bekannte Meßmethodik dargestellt, die mit Spinechoverfahren bezeichnet wird. Dieses Spinechoverfahren kann einen Teil des erfindungsgemäßen Verfahrens darstellen, was weiter unten näher erläutert wird. Vor dem Zeitpunkt t = 0 schalten die Steuermittel 16b den Generator 13 zum Erzeugen eines Magnetfeldgradienten Gz ein, so daß, wenn zum Zeitpunkt t = 0 die Steuermittel 16b den Sender 14 zum Erzeugen eines Hf-Impulses P1 einschalten, der meistens ein 90°-Impuls ist, die Kernspins in einer beliebig orientierten ausgewählten Ebene eines Objekts, das im Untersuchungsraum 11 angeordnet ist, angeregt werden. Am Ende des Hf-Impulses P1 und vor einem folgenden Hf-Impuls P2 wird ein zweites Magnetfeld mit dem Gradienten Gy sowie ein drittes Magnetfeld mit dem Gradienten Gx eingeschaltet, wobei für jeden Meßzyklus das Zeitintegral des Magnetfeldgradienten Gy verschieden ist. Bekanntlich wird mit dem Zeitintegral des Magnetfelds mit dem Gradienten Gy eine Bildfrequenz ky gewählt und für jeden Wert von ky das Kernspinresonanzsignal abhängig von der Bildfrequenz kx gemessen, wobei kx vom Zeitintegral des Magnetfelds mit dem Gradienten Gx bestimmt wird. Zum Zeitpunkt t1 wird der Hf-Impuls P2, ein sog. Echoimpuls erzeugt, der meistens ein 180°-Impuls ist, so daß etwa zum Zeitpunkt t2, bei dem die Zeitdauer zwischen der Zeit t = 0 und t1 und die Zeitdauer zwischen t1 und t2 gleich sind, ein Echosignal E erzeugt wird, das bei einem Magnetfeldgradienten Gx abgetastet wird. Die Amplitude dieses Signals E ist eine Funktion der Kernspindichte $\rho$ und der Relaxationszeiten T1 und T2.

Selbstverständlich kann nach der Abtastperiode Tm, in der die Signalproben des Echosignals E gezogen werden, mit einem folgenden 180°-Impuls ein neues Echosignal erzeugt und abgetastet werden. Wenn dabei außerdem der Magnetfeldgradient Gy zuvor vorübergehend eingeschaltet wird, bietet dies den Vorteil, daß die erforderliche Zeit zum Ziehen genügender Signalproben verkürzt wird. Auch diese Methodik ist an sich bekannt. Faktisch kann die beschriebene Erfindung bei allen Meßmethodiken, bei denen Impuls- oder Feldechos erzeugt werden, verwendet werden. Das mit einer derartigen Meßmethodik erzeugte Echosignal ist abhängig von der Zeit mit der Funktion exp(-t/T2) gewichtet. In Fig. 2 ist dieser Gewichtungsfaktor als Funktion W dargestellt.

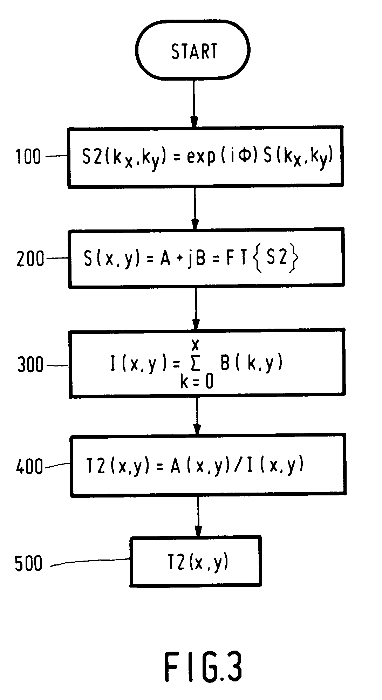

Das Ablaufdiagramm der Fig. 3 zeigt die Verarbeitung der Signalproben, die mit der Meßmethodik der Fig. 2 erhalten wurden. Diese Signalproben sind abhängig von den Bildfrequenzen kx und ky erhalten, die durch das Zeitintegral der Stärke der betreffenden Magnetfeldgradienten Gx und Gy bestimmt werden, wobei dieses Integral vom Anregungsimpuls bis zum Zeitpunkt verläuft, zu dem eine Signalprobe gezogen wird.

In einem ersten Schritt 100 des Ablaufdiagramms wird die Phase der Signalproben S(kx,ky) nötigenfalls korrigiert, was mit dem Ausdruck exp-(i$\phi$) wiedergegeben und an sich bekannt ist. Alternativ könnte statt dieser Phasenkorrektur vor der Fouriertransformation auch eine Korrektur der Signale nach der Fouriertransformation durchgeführt werden.

Wie in einem zweiten Schritt 200 des Ablaufdiagramms angegeben ist, wird aus der auf diese Weise erhaltenen Bildfrequenzmatrix S2(kx,ky) durch Fourier-Transformation eine Verteilung S(x,y) bestimmt. Wenn die Transversal-Relaxationszeit T2 keinen Einfluß gehabt hätte, wäre hiermit die Kernspindichte $\rho$(x,y) gefunden, denn S(kx,ky) und $\rho$-(x,y) hätten dabei ein Fourier-Paar gebildet. In Wirklichkeit spielt die Zeit T2 immer eine Rolle und die erfaßte Bildfrequenzmatrix S(kx,ky) ist die Fouriertransformierte des Produkts von $\rho$(x,y) und der Gewichtungsfunktion W = exp(-t/T2(x,y)).

Die Gewichtungsfunktion W läßt sich als exp(-($\tau$ + TE)/T2) neuschreiben. Dabei ist TE die Zeit zwischen dem Impuls P1 zum Zeitpunkt t = 0 und der Mitte ( = t2) des Echosignals E, beide in Fig. 2 dargestellt. Die Zeit $\tau$ wird vom Zeitpunkt t = TE berechnet und kann also sowohl positive als auch negative Werte annehmen. Die so geschriebene Gewichtungsfunktion W kann als Funktion von $\tau$ in einen symmetrischen Teil SD und einen anti-symmetrischen Teil AD zerlegt werden: W = SD + AD, worin SD = exp(-TE/T2) * cosh($\tau$/T2) und AD = -exp(-TE/T2) * sinh($\tau$/T2). Diese Ausdrücke für den symmetrischen Teil SD und den anti-symmetrischen Teil AD der Gewichtungsfunktion zeigen sich vereinfachbar zu SD = exp(-TE/T2) und AD = (-$\tau$/T2) * exp(-TE/T2), weil das damit gewichtete Signal außerhalb $\tau$ = 0 schnell nach 0 geht.

Bei einer gegebenen Verteilung von $\rho$ wird der reale Anteil A des im Schritt 200 gewonnenen Signals S(x,y) nur noch vom symmetrischen Teil SD der Gewichtungsfunktion W bestimmt; dieser reale Anteil A ist gleich $\rho$ * exp(-TE/T2). Der imaginäre Anteil B des Signals S(x,y) wird bei einer gegebenen Verteilung von $\rho$ nur noch vom antisymmetrischen Teil AD der Gewichtungsfunktion W bestimmt. Aus dem zuletzt gegebenen Ausdruck für AD ist ableitbar, daß dieser imaginäre Anteil B gleich -d/dx{C * $\rho$/T2 * exp(-TE/T2)} ist, wobei C eine Konstante ist, abhängig von der Stärke des Lesegradienten und vom gyromagnetischen Verhältnis des detektierten Kerns, wobei x die Koordinate entsprechend der Richtung des Lesegradienten ist.

Nach einem dritten Schritt 300 des Ablaufdiagramms wird der imaginäre Anteil B des Signals S-(x,y) über die Koordinate x integriert und durch den Faktor -C geteilt. Die laufenden Integralwerte des Signals B bilden ein neues Signal I(x,y), das durch den Ausdruck $\rho$/T2 * exp(-TE/T2) beschrieben wird.

Wie in einem vierten Schritt 400 des Ablaufdiagramms angegeben ist, wird je Bildelement der Quotient des Signals A(x,y) und des integrierten Signals I(x,y) bestimmt. Dies erfolgt für alle Bildelemente. Aus den angegebenen Ausdrücken für diese Signale folgt, daß dieser Quotient gleich der Transversal-Relaxationszeit T2 ist. Die Ungenauigkeit des benutzten Ausdrucks für I(x,y) führt im übrigen zu geringen Unterschieden zwischen diesem Quotienten und dem realen Wert von T2. Ein so gewonnenes Bild der Zeit T2 kann in einem folgenden Schritt 500 an der Wiedergabeanordnung 17 dargestellt werden (siehe Fig. 1).

**Patentansprüche**

1. Bildgebendes Verfahren auf der Basis einer Kernspinparameterverteilung in einem Teil eines Körpers, wobei, während einer Anzahl von Meßzyklen, in einem statischen Magnetfeld im Körper Kernspins zum Erzeugen eines Kernspinresonanzsignals (E) angeregt werden, das darauf bei einem dem statischen Magnetfeld überlagerten Magnetfeldgradienten (Gx) abgetastet wird, wobei ein zweiter Magnetfeldgradient (Gy), mit einem von Meßzyklus zu Meßzyklus unterschiedlichen Zeitintegral, vor dem Resonanzsignal (E) vorübergehend eingeschaltet ist, wonach die auf diese Weise abgetasteten Resonanzsignale (E) durch Signaltransformation (200) in ein Bild der vorgenannten Verteilung umgesetzt werden, dadurch gekennzeichnet, daß die erzeugten Kernspinresonanzsignale (E) Spinechosignale oder Gradientenechosignale sind, daß die Kernspinparameterverteilung eine Transversal-Relaxationszeitverteilung ist und daß aus der zeitlichen Asymmetrie des abgetasteten Kernspinresonanzsignals (E) bezüglich seines Signalmaximums, die durch die Transversal-Relaxation der angeregten Kernspins verursacht wird, ein Maß für die ortsabhängige Verteilung der Transversal-Relaxationszeit (T2) abgeleitet wird.

2. Verfahren zum Bestimmen der Kernspindichteverteilung und der Verteilung der Transversal-Relaxationszeit T2 in einem Teil eines Körpers, wobei im Körper, während einer Anzahl von Meßzyklen, bei einem statischen Magnetfeld Kernspins zum Erzeugen eines Kernspinresonanzsignals (E) angeregt werden, und aus den auf diese Weise gewonnenen Resonanzsignalen (E) durch Signaltransformation (200, 400) obige Verteilungen bestimmt werden, dadurch gekennzeichnet, daß das Kernspinresonanzsignal (E) bei einem Magnetfeldgradienten (Gx) abgetastet wird, der dem statischen Magnetfeld überlagert ist und eine erste Richtung hat, daß ein zweiter Magnetfeldgradient (Gy) in einer zweiten Richtung, mit einem von Meßzyklus zu Meßzyklus unterschiedlichen Zeitintegral, vor dem Resonanzsignal (E) vorübergehend eingeschaltet ist, daß die Signaltransformation eine Fouriertransformation enthält, daß das Kernspinresonanzsignal (E) ein Spinechosignal oder Gradientenechosignal ist, das mit einer derartigen Phase erfaßt oder dessen Phase vor oder nach der Fouriertransformation derart korrigiert wird, daß das Ergebnis der Fouriertransformation und der gegebenenfalls danach durchgeführten Korrektur, ohne Transversal-Relaxation rein reell wäre, und daß nach der Fouriertransformation und gegebenenfalls der Korrektur von Signalproben der Kernspinresonanzsignale (E) der Imaginärteil der transformierten Signale in der ersten Richtung integriert wird, wonach die Verteilung der Transversal-Relaxationszeit (T2) aus dem Quotienten des Realteils und des integrierten Imaginärteils der transformierten Signale bestimmt wird, und daß die Kernspindichteverteilung aus der so bestimmten Verteilung der Transversal-Relaxationszeit (T2) und dem Realteil der transformierten Signale oder auf andere Weise durch Signaltransformation der abgetasteten Resonanzsignale bestimmt wird.

3. Verfahren nach Anspruch 2, wobei von einer derart bestimmten Verteilung ein aus Bildelementen bestehendes Bild konstruiert wird, dadurch gekennzeichnet daß für jene Bildelemente, deren integrierter Imaginärteil der transformierten Signale zur Bestimmung des genannten Quotienten zu klein ist, die Bestimmung des Quotienten durch eine andere Bearbeitung, wie z.B. eine Interpolation aus umgebenden Bildelementen, ersetzt wird.

**4.** Verfahren nach Anspruch 2, dadurch gekennzeichnet, daß die Integration von Signalen nach der Fouriertransformation durch eine signalbearbeitungstechnisch gleichwertige Bearbeitung für die Fouriertransformation ersetzt wird, d.h. durch Filterung mit einer Filterfunktion gleich der Gewichtungsfunktion (1/t) oder einer davon abgeleiteten Gewichtungsfunktion.

**5.** Verfahren nach Anspruch 2, 3 oder 4, wobei von einer derart bestimmten Verteilung ein aus Bildelementen bestehendes Bild konstruiert wird, dadurch gekennzeichnet, daß der für jedes Bildelement bestimmte Quotient als Einschätzung der Transversalrelaxationszeit T2 verwendet wird.

**6.** Verfahren nach Anspruch 2, 3 oder 5 wenn abhängig von Anspruch 2 oder 3, wobei von einer derart bestimmten Verteilung ein aus Bildelementen bestehendes Bild konstruiert wird, dadurch gekennzeichnet, daß die Imaginärteile der Fouriertransformierten der erhaltenen Signale, gegebenenfalls korrigiert, mittels eines laufenden Integrals in die genannte erste Richtung integriert werden und daß zur Bestimmung der Verteilung der Transversal-Relaxationszeit T2, für jedes Bildelement der dazu gehörende Realteil der erwähnten Fouriertransformierten durch das Ergebnis dieses laufenden Integrals auf die Position des Bildelements geteilt wird.

**7.** Kernspinresonanzanordnung mit einem Magnetsystem (10, 12, 13) zum Erzeugen eines statischen homogenen Magnetfeldes und zum Erzeugen von Magnetfeldgradienten, mit einem Hf-Sender/Empfänger (14, 15) zum Erzeugen und Detektieren von Kernspinresonanzsignalen (E), mit einer Abtastanordnung zum Abtasten der erzeugten Resonanzsignale, mit einer Signaltransformationsanordnung (16a) zum Transformieren der abgetasteten Kernspinresonanzsignale, mit einer Wiedergabeanordnung (17) zum Wiedergeben der transformierten Signale, und mit einer Steueranordnung (16b) zum Steuern des Magnetsystems (10, 12, 13), des Hf-Senders/Empfängers (14, 15), der Abtastanordnung, der Signaltransformationsanordnung (16a) und der Wiedergabeanordnung (17), dadurch gekennzeichnet, daß die Kernspinresonanzsignale (E) Spinechosignale oder Gradientenechosignale sind, daß die Abtastanordnung zum Erfassen der Resonanzsignale mit einer derartigen Phase angepaßt ist oder daß Korrekturmittel für eine derartige Korrektur der Signalphase vor oder nach der Transformation vorgesehen sind, daß das Ergebnis der Transformation und der gegebenenfalls danach durchgeführten Korrektur, ohne Transversal-Relaxation rein reell wäre, und daß die Signaltransformationsanordnung (16a) Rechenmittel zum Integrieren der Imaginärteile der Signaltransformierten der abgetasteten Kernspinresonanzsignale und zum Bestimmen des Quotienten der Realteile der Signaltransformierten und dieser integrierten Imaginärteile enthält.

**8.** Kernspinresonanzanordnung nach Anspruch 7, in der die Signaltransformationsanordnung (16a) eine Fouriertransformation durchführt und Speichermittel zum Speichern der Real- und Imaginärteile der Fouriertransformierten der Kernspinresonanzsignale (E) enthält, dadurch gekennzeichnet, daß weitere Speichermittel zum Speichern der Integralwerte der Imaginärteile und/oder zum Speichern des Quotienten der Realteile der Fouriertransformierten und der zugeordneten Werte dieses Integrals vorgesehen sind.

**Claims**

**1.** An image-frequency method, based on a nuclear spin parameter distribution in a part of body, where nuclear spins are excited in the body during a number of measuring cycles in the presence of a steady magnetic field in order to generate a spin resonance signal (E) which is subsequently sampled in the presence of a magnetic field gradient (Gx) which is superposed on the steady magnetic field, a second magnetic field gradient (Gy) with a time integral which differs from one measuring cycle to another being temporarily switched on prior to the resonance signal (E), after which the resonance signals (E) thus sampled are converted into an image of said distribution by signal transformation (200), characterized int hat the spin resonance signals (E) generated are spin echo signals or gradient echo signals, that the nuclear spin parameter distribution is a transverse relaxation time distribution, and that from the temporal asymmetry of the sampled spin resonance signal (E), relative to its signal maximum, caused by the transverse relaxation of the excited spins, there is derived a measure of the location-dependent distribution of the transverse relaxation time (T2).

**2.** A method for determining the spin density distribution and the distribution f the transverse relaxation time T2 in a part of a body, where nuclear spins are excited in the body during a number of measuring cycles in the presence of a steady magnetic field in order to generate a spin resonance signal (E), said distributions being determined by signal transformation (200,400) from the resonance signals (E)thus acquired, characterized in that the spin resonance signal (E) is sampled in the presence of a magnetic field gradient (Gx), having a first direction, which is superposed on the steady magnetic field, that a second magnetic field gradient (Gy) in a second direction, having a time integral which differs from one measuring cycle to another, is temporarily switched on prior to the resonance signal (E), that the signal transformation includes a Fourier transformation, that the spin resonance signal (E) is a spin echo signal or a gradient signal which is detected with such a phase, or whose phase is corrected before or after the Fourier transformation in such a manner, that the result of the Fourier transformation and the possibly subsequently executed correction would be purely real in the absence of transverse relaxation, that after the Fourier transformation and possibly the correction of signal samples of the spin resonance signals (E) the imaginary part of the transformed signals is integrated in the first direction, after which the distribution of the transverse relaxation time (T2) is determined from the quotient of the real part and the integrated imaginary part of the transformed signals, and that the spin density distribution is determined from the distribution of the transverse relaxation time (T2) thus determined and from the real part of the transformed signals, or in a different manner by signal transformation of the sampled resonance signals.

3. A method as claimed in Claim 2, where an image consisting of pixels is constructed from a distribution thus determined, characterized in that for those pixels whose integrated imaginary part of the transformed signals is too small for determining said quotient the determination of the quotient is replaced by another operation such as, for example an interpolation from surrounding pixels.

4. A method as claimed in Claim 2, characterized in that the integration of signals after the Fourier transformation is replaced by an operation which is equivalent to the Fourier transformation from a signal-processing point of view, i.e. by filtering with a filter function which is equal to the weighting function (1/t) or a weighting function derived therefrom.

5. A method as claimed in Claim 2, 3 or 4, where an image consisting of pixels is constructed from a distribution thus determined, characterized in that the quotient determined for each pixel is used as an estimate of the transverse relaxation time T2.

6. A method as claimed in Claim 2, 3 or 5 when dependent on Claim 2 or 3, where an image consisting of pixels is constructed from a distribution thus determined, characterized in the imaginary parts of the fourier transform of the, possibly corrected, signals obtained are integrated in said first direction by means of a running integral, and that for the determination of the distribution of the transverse relaxation time T2 for each pixel the associated real part of said Fourier transform is divided by the result of said running integral on the position of the pixel.

7. A nuclear magnetic resonance arrangement comprising a magnet system (10, 12, 13) for generating a steady, uniform magnetic field and for generating magnetic field gradients, and also comprising an RF transmitter/receiver (14, 15) for generating and detecting spin resonance signals (E), a sampling device for sampling the resonance signals generated, a signal transformation device (16a) for transforming the sampled spin resonance signals, a display device (17) for displaying the transformed signals, and a control device (16b) for controlling the magnet system (10, 12, 13), the RF transmitter/receiver (14, 15), the sampling device, the signal transformation device (16a), and the display device (17), characterized in that the spin resonance signals (E) are spin echo signals or gradient echo signals, that the sampling device for acquiring the resonance signals is adapted with such a phase, or that there are provided correction means for such a correction of the signal phase before or after the transformation, that the result of the transformation and the possibly subsequently executed correction would be purely real in the absence of transverse relaxation, and that the signal transformation device (16a) comprises arithmetic means for integrating the imaginary parts of the signal transform of the sampled spin resonance signals and for determining the quotient of the real parts of the signal transform and said integrated imaginary parts.

8. An NMR arrangement as claimed in Claim 7, in which the signal transformation device (16a) performs a Fourier transformation and comprises storage means for storing the real and the imaginary parts of the Fourier transform of te spin resonance signals (E), characterised in that there are provided further storage means for storing the integral values of the imaginary parts and/or for storing the quotient of the real parts of the Fourier transform and the associated values of this integral.

## Revendications

1. Procédé d'imagerie basé sur une répartition des paramètres de spin nucléaire dans une partie d'un corps, suivant lequel, des spins nucléaires sont excités dans le corps, dans un champ magnétique statique, pendant un certain nombre de cycles de mesure pour produire un signal de résonance de spin nucléaire (E) qui est ensuite échantillonné lors d'un gradient de champ magnétique (Gx) superposé au champ magnétique statique, un deuxième gradient de champ magnétique (Gy) étant enclenché transitoirement, avec une intégrale dans le temps différente d'un cycle de mesure à l'autre, avant le signal de résonance (E), après quoi les signaux de résonance (E) échantillonnés de cette façon sont convertis par transformation de signaux (200) en une image de la répartition précitée, caractérisé en ce que les signaux de résonance de spin nucléaire produits (E) sont des signaux d'écho de spin ou des signaux d'écho de gradient, que la répartition des paramètres de spin nucléaire est une répartition des temps de relaxation transversale et qu'à partir de l'asymétrie temporelle du signal de résonance de spin nucléaire (E) échantillonné pour son maximum de signal qui est provoqué par la relaxation transversale du spin nucléaire excité, est déduite une mesure de la répartition locale du temps de relaxation transversale (T2).

2. Procédé pour la détermination de la répartition de la densité de spin nucléaire et de la répartition du temps de relaxation transversale (T2)- dans une partie d'un corps, suivant lequel des spins nucléaires sont excités dans le corps pendant un certain nombre de cycles de mesure, lors d'un champ magnétique statique pour produire un signal de résonance de spin (E) et les répartitions précitées sont déterminées par transformation de signaux (200, 400) à partir des signaux de résonance (E) obtenus de cette façon, caractérisé en ce que le signal de résonance de spin nucléaire (E) est échantillonné, lors d'un gradient de champ magnétique (Gx) qui est superposé au champ magnétique statique et a une première direction, qu'un deuxième gradient de champ magnétique (Gy) est enclenché de façon transitoire dans une deuxième direction avec une intégrale dans le temps différente d'un cycle de mesure à l'autre, avant le signal de résonance (E), que la transformation de signaux contient une transformation de Fourier, que le signal de résonance de spin nucléaire (E) est un signal d'écho de spin ou un signal d'écho de gradient qui est capté avec une telle phase ou dont la phase est corrigée avant ou après la transformation de Fourier, de telle façon que le résultat de la transformation de Fourier et de la correction éventuellement exécutée ensuite sans relaxation transversale serait purement réel, et qu'après la transformation de Fourier et éventuellement la correction d'échantillons de signaux des signaux de résonance de spin nucléaire (E), la partie imaginaire des signaux transformés est intégrée dans une première direction, après quoi la répartition du temps de relaxation transversale (T2) est déterminée à partir du quotient de la partie réelle et de la partie imaginaire intégrée des signaux transformés, et que la répartition de densité des spins nucléaires est déterminée par transformation de signaux des signaux de résonance échantillonnés, à partir de la répartition ainsi déterminée du temps de relaxation transversale (T2)et de la partie réelle des signaux transformés ou d'une autre manière.

3. Procédé suivant la revendication 2, dans lequel une image formée d'éléments d'image est construite au départ d'une répartition ainsi déterminée, caractérisé en ce que pour chaque élément d'image dont la partie imaginaire intégrée des signaux transformés est trop petite pour la détermination du quotient précité, la détermination du quotient est remplacée par une autre opération, comme par exemple une interpolation entre des éléments d'image voisins.

4. Procédé suivant la revendication 2, caractérisé en ce que l'intégration de signaux, après la transformation de Fourier, est remplacée par une opération équivalente à la transformation de Fourier en matière de transformation de signaux, à savoir par filtrage au moyen d'une fonction filtre égale à la fonction de pondération (1/t) ou à une fonction de pondération qui en est déduite.

5. Procédé suivant la revendication 2, 3 ou 4, suivant lequel une image consistant en éléments d'image est construite à partir d'une répartition déterminée de la sorte, caractérisé en ce que le quotient déterminé pour chaque élément d'image est utilisé sous la forme d'une évaluation du temps de relaxation transversale T2.

**6.** Procédé suivant la revendication 2, 3 ou 5 découlant de la revendication 2 ou 3, suivant lequel une image formée d'éléments d'image est construite au départ d'une répartition déterminée de la sorte, caractérisé en ce que, la partie imaginaire des transformées de Fourier des signaux obtenus, éventuellement corrigés, est intégrée dans la première direction citée au moyen d'une intégrale courante et en ce que, pour la détermination de la répartition du temps de relaxation transversale T2, pour chaque élément d'image, la partie réelle y afférente des transformées de Fourier citées est divisée par le résultat de cette intégrale courante sur la position de l'élément d'image.

**7.** Dispositif de résonance de spin nucléaire comprenant un système d'aimant (10, 12, 13) pour produire un champ magnétique homogène statique et pour produire des gradients de champ magnétique, un émetteur/récepteur de haute fréquence (14, 15) pour produire et détecter des signaux de résonance de spin nucléaire (E), un dispositif d'échantillonnage pour échantillonner les signaux de résonance produits, un dispositif de transformation de signaux (16a) pour transformer les signaux de résonance de spin nucléaire échantillonnés, un dispositif d'affichage (17) pour afficher les signaux transformés et un dispositif de commande (16b) pour commander le système d'aimant (10, 12, 13), l'émetteur/récepteur de haute fréquence (14, 15), le dispositif d'échantillonnage, le dispositif de transformation de signaux (16a) et le dispositif d'affichage (17), caractérisé en ce que les signaux de résonance de spin nucléaire (E) sont des signaux d'écho de spin ou des signaux d'écho de gradient, que le dispositif d'échantillonnage pour capter les signaux de résonance est ajusté à une phase telle ou que des moyens de correction sont prévus pour une correction des phases des signaux avant ou après la formation telle que le résultat de la transformation et de la correction éventuellement exécutée ensuite sans relaxation transversale serait une valeur purement réelle et que le dispositif de transformation de signaux (16a) contient des moyens de calcul pour intégrer les parties imaginaires des transformées de signaux des signaux de résonance de spin nucléaire échantillonnés et pour déterminer le quotient des parties réelles des transformées de signaux et de leurs parties imaginaires intégrées.

**8.** Dispositif de résonance nucléaire suivant la revendication 7, dans lequel le dispositif de transformation de signaux (16a) exécute une transformation de Fourier et comprend des moyens de mémoire pour stocker les parties réelles et imaginaires des transformées de Fourier des signaux de résonance de spin nucléaire (E), caractérisé en ce que d'autres moyens de mémoire sont prévus pour stocker les valeurs intégrales des parties imaginaires et/ou pour stocker les quotients des parties réelles des transformées de Fourier et des valeurs afférentes de cette intégrale.

# FIG.1

# FIG.2

11

START

100 — $S2(k_x,k_y) = \exp(i\Phi)\, S(k_x,k_y)$

200 — $S(x,y) = A + jB = FT\{S2\}$

300 — $I(x,y) = \sum_{k=0}^{x} B(k,y)$

400 — $T2(x,y) = A(x,y)/I(x,y)$

500 — $T2(x,y)$

FIG.3